(19) Europäisches Patentamt
European Patent Office
Office européen des brevets

(11) Publication number: 0 341 834 B1

# (12) EUROPEAN PATENT SPECIFICATION

(45) Date of publication of patent specification: **15.09.93** (51) Int. Cl.5: **H03L 7/107**

(21) Application number: **89303660.8**

(22) Date of filing: **13.04.89**

## (54) Phase locked loop with bandwidth ramp.

(30) Priority: **12.05.88 US 193337**

(43) Date of publication of application:
**15.11.89 Bulletin 89/46**

(45) Publication of the grant of the patent:
**15.09.93 Bulletin 93/37**

(84) Designated Contracting States:
**DE FR GB IT NL**

(56) References cited:
**GB-A- 2 026 288**

**PATENT ABSTRACTS OF JAPAN, vol. 12, no. 277 (E-640), 30th July 1988; & JP-A-63 056 018 (FUJITSU LTD) 10-03-1988**

**RADIO FERNSEHEN ELEKTRONIK, vol. 32, no. 4, 1983, page 262, Berlin, DE; R. LIEBOLD: "Verbesserung des Einrastverhaltens von Phasenregelkreisen"**

**PATENT ABSTRACTS OF JAPAN, vol. 6, no. 243 (E-145)[1121], 2nd December 1982; & JP-A-57 141 137 (FUJITSU K.K.) 01-09-1982**

(73) Proprietor: **DIGITAL EQUIPMENT CORPORATION**
**146 Main Street**
**Maynard, MA 01754-1418(US)**

(72) Inventor: **Leis, Michael D.**
**177 Edmands Road**
**Framingham Massachusetts 01701(US)**
Inventor: **Engleson, Gary Stewart**
**59 Mercury Drive**
**Shrewsbury, Massachusetts 01545(US)**
Inventor: **Lawrence, Bruce James**
**710 Grove Street**
**Worcester, Massachusetts 01606(US)**

(74) Representative: **Goodman, Christopher et al**
**Eric Potter & Clarkson St. Mary's Court St. Mary's Gate**
**Nottingham NG1 1LE (GB)**

EP 0 341 834 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

### FIELD OF THE INVENTION

This invention relates generally to the field of phase locked loops, and particularly to a phase locked loop where the bandwidth is slowly decreased to reduce lock acquisition time and noise sensitivity.

### BACKGROUND OF THE INVENTION

It is often necessary in a data processing system to read an input data signal from a peripheral device which does not provide a synchronized clock signal. Such a situation may occur, for example, at the interface between a disk drive controller and a disk drive, or at the interface of an asynchronous communications controller and its associated asynchronous communication device. To enable reading of the input signal, a local oscillator must normally be synchronized to transitions found in the input signal itself.

With the typical scenario, local oscillator synchronization is achieved by using an input signal which has two portions. A preamble portion, consisting of closely spaced transitions created by an alternating pattern of logical ones and logical zeros, precedes a data portion which contains the information to be read. The preamble portion is fed to a phase locked loop (PLL). As is well known a PLL provides a continuous output signal which is phase and frequency locked to its input signal. Phase and frequency lock will occur if the preamble portion is sufficiently long in time to guarantee that the loop reaches a stable state. A suitable clock signal synchronized to the input signal is thus provided at the output of the phase locked loop once the stable state is reached.

A critical design decision in this situation is selecting the phase locked loop bandwidth, since the maximum possible time that it can take for the loop to lock, called the settling time, is inversely proportional to the loop bandwidth. Thus, the larger the loop bandwidth, the shorter the preamble portion can be, and the more time can be spent reading data. Unfortunately, loop bandwidth is also directly proportional to noise susceptibility. Thus, the wider the bandwidth, the more unstable the loop becomes, and the smaller the tolerance to noise in the data portion.

One way to avoid this problem has been to begin with a relatively high loop bandwidth while the PLL is locking to the preamble. At the end of the preamble, a narrower bandwidth loop filter is switched in. This arrangement provides both the advantages of fast settling time during lock acquisition, and greatest noise immunity after the PLL has locked, while the data is being read. This switch to a narrower bandwidth also helps noise immunity because the signal to noise ratio usually increases during the data portion due to intersymbol interference.

While this approach has been found adequate in most situations, it is not generally known that other problems exist. One such problem is that a noise pulse occurring just before the end of the preamble may cause a large loop error. Because the loop bandwidth is then narrowed, this large loop error can take a very long time to settle out, during which time the loop is not completely locked. This translates into increased occurrence of data recovery errors. When data is lost, of course, the peripheral must be re-accessed, thereby increasing the overall data read time.

A second problem is caused by the act of changing the loop bandwidth itself. Because this normally involves switching circuit components in and out of the loop, any resulting switching transients often are large enough to perturb the loop. The error thus caused must also be corrected at the lower bandwidth, which takes a much longer time than if the bandwidth had never been decreased.

Another problem in this scenario is due to mismatches caused by the change in bandwidth. For example, the loop circuits can be designed to have nearly perfect impedance and current loading characteristics for a particular bandwidth. However, if that bandwidth is then narrowed or widened, the actual circuit transfer function will drift away from what is desired.

The first problem is a result of changes in the signal fed to the input of the loop. The latter two problems are both caused by changes in the transfer function of the loop as its bandwidth changes. Considering that the response of a system depends upon the frequency response of its input times its transfer function is another way to see why these problems have the observed effect.

In applications such as disk drive controllers, phase synchronization must constantly be reacquired every time a different sector on the disk is selected for access. Since the time spent reading and locking to the preamble portion is time not spent reading data, the need for long preambles can adversely affect the data transfer rate of the disk drive. Perhaps even more importantly in disk drive applications, the needed for longer preambles decreases the usable storage capacity of the drive.

## SUMMARY OF THE INVENTION

In brief summary, a phase locked loop constructed in accordance with the invention has an input control for varying the loop response time. The response time is exponentially reduced over a period of time at least as long as a loop time constant equal to the reciprocal of the natural frequency of the loop at its beginning, or largest bandwidth exponentially. Preferably, the bandwidth reduction takes place over a period of time longer than several time constants.

The loop response time is changed by reducing the loop bandwidth. One way to adequately reduce the bandwidth is to slowly decrease the gain of the loop. In feedback control systems, and especially the typical second order linear system, the loop bandwidth is directly proportional to the square root of the gain.

The loop gain or bandwidth may be decreased in any suitable fashion. One preferred embodiment uses an exponential decrease, since that perturbs the loop minimally. An exponential change is optimum in the sense that the largest changes in loop bandwidth occur nearest the beginning of the preamble portion, when the loop bandwidth is greatest, and when the most time is available for the changes to occur.

Whereas it was previously thought ideal to complete the gain or bandwidth reduction before the end of the preamble, it has been found that this reduction is preferably extented into the data portion to further reduce noise susceptibility.

There are certain advantages realized with this arrangement. The loop is noticeably less susceptible to noise perturbations occurring near the end of the preamble, with the noise susceptibility reduced in proportion to the time left to attain full phase lock. The loop itself also settles in a shorter time, since the act of switching to the narrower bandwidth occurs slowly thereby markedly reducing bandwidth switching transients. Therefore, the preamble portion of the input signal may be shortened, which allows the data portion to be longer. This in turn enables more data to be stored on a given disk. The shorter lock time is important when reading data from a disk drive, since the loop needs to be repeatedly re-locked to a different preamble every time a different sector of the disk is accessed.

## BRIEF DESCRIPTION OF THE DRAWINGS

This invention is pointed out with particularity in the appended claims. The above and further advantages of the invention may be better understood by referring to the following description in conjunction with the accompanying drawings, in which:

Fig. 1 depicts a block diagram of a phase locked loop constructed in accordance with the invention;

Fig. 2 is a block diagram of one embodiment of the invention which uses a charge pump having a gain control input fed by a ramp signal generator;

Fig. 3 is a detailed circuit diagram of one embodiment of the signal generator shown in Fig. 2; and

Figs. 4A, 4B, and 4C are the results of computer simulations showing the reduced noise susceptibility and shortened loop lock time possible with the invention.

## DETAILED DESCRIPTION OF ILLUSTRATIVE EMBODIMENTS

Referring now to Fig. 1, there is shown a block diagram of a phase lock loop 10 (PLL) constructed in accordance with known techniques. The PLL 10 is connected to operate on an loop input signal 12 received from a peripheral device 14 such as a disk drive. In the illustrated application, the loop input signal 12 is a digital output signal from a signal processor 11 which receives the output of a read/write head 16 associated with the drive 14. The PLL 10 includes a phase detector 20, a loop filter 22, a loop amplifier 24, and a voltage controlled oscillator (VCO) 26 connected in series. The phase detector 20 provides a voltage indicative of the phase difference between the loop input signal 12 and a VCO output 27 provided by the VCO 26. This difference is then filtered by loop filter 22 and amplified by loop amplifier 24 before being used to control the VCO 26. The illustrated PLL 10 is a type of PLL often called a second order loop, since the highest power of "s" in the denominator of its closed-loop transfer function is two.

The VCO 26 provides a loop output signal 28 which is phase and frequency locked to the loop input signal 12. Specifically, the loop output signal 28 is locked to a preamble portion 34 of the loop input signal 12 which occurs before a time $t_2$. The function of the PLL 10 is to acquire phase and frequency lock to the preamble portion 34 of the loop input signal 12. The loop output signal 28 is then used to track information encoded as data in a data portion 36 of the loop input signal 12. This is typically accomplished by feeding the loop output signal 28 to a data register (not shown the Figures) arranged to receive the data portion 36 of the loop input signal 12. The operation of the PLL 10 on the preamble portion 34 is sometimes referred to as an acquisition sequence (ACK) and operations on the data portion 36 as a track sequence (TRACK).

It should also be noted that the response time, or "time constant" of the PLL 10 is adjustable. That is, the loop response time of PLL 10 may be changed by adjusting either the bandwidth of the loop filter 22 directly, or indirectly, by changing the gain of the loop amplifier 24. As Fig. 1 indicates, the bandwidth of the loop filter 22 is adjusted by changing the value of a bandwidth control 21 input on the loop filter 22. Since for second order loops it can be shown that the bandwidth is also directly related to the gain, the loop response time may also be adjusted by changing the value of a gain control 23 input on the loop amplifier 24. As indicated in the plot 38 of the bandwidth control 21, $f_c(t)$, or gain control 23, k(t), versus time, the loop response time is slowly decreased from an initial value $v_{go}$ set at the beginning of the preamble to a final value $V_{end}$ reached near the beginning of the occurrence of the data portion 36 at time $t_2$. The response time is held at the higher value $v_{go}$ until a time $t_1$ which is some point in the middle of the preamble portion 34, after the PLL 10 has begun to acquire phase lock.

What is an important and distinguishing feature of this invention is that the change in response time, be it accomplished through a bandwidth change or a gain change, occurs exponentially over a time interval $t_2$ - $t_1$. This time interval $t_2$ - $t_1$ must be at least as long as the time constant of the loop, $\gamma$. The loop time constant $\gamma$ is equivalent to the reciprocal of the natural frequency $w_c$ of the loop. Since the loop parameters are dynamic, the $w_c$ spoken of here preferably is the $w_c$ of the loop before time $t_1$, when the response time is greatest (ie., the bandwidth is widest).

Fig. 2 is a high-level circuit diagram of one embodiment of a PLL 10 according to this invention. This implementation uses a lead-lag type phase comparator 4O to compare the difference between the phase of the preamble portion 34 and the VCO output 27 from the VCO 26. The means for adjusting the loop response time is provided by a charge pump 42. The charge pump 42 consists of a positive charge source 44, a negative charge source 46, a capacitor 48, and a discharge control resistor 49. The amount of charge provided by positive charge source 44 or negative charge source 46 to the capacitor 48 is controlled by a signal from the control signal generator 50, in addition to the normal control via its input commands 52 and 54. One embodiment of generator 50 is shown in greater detail in Fig. 3, which is discussed later.

Still referring to Fig. 2, but more particularly now, the phase comparator 40 provides either lag or lead output pulses depending upon whether the transitions of the VCO output 27 occur before or after transitions of the preamble 34, respectively. The lag pulses are provided on a lag output 54 line, and the lead pulses on a lead output 52 line. The width of the lead and lag pulses so provided is proportional to the time difference between the pulses.

If lead pulses exist at the lead output 52, this indicates the VCO 26 is phase-leading, and that its input voltage must be decreased. Accordingly, then, the lead output 52 is fed to control the negative charge source 46. The negative charge source 46 then sinks a current on a charge pump output line 45 to decrease the charge on the capacitor 48 through the discharge control resistor 49. The amount of current sunk by negative charge source 46 is directly proportional to both the width of the pulses received on lead output 52 as well as the value of a response control signal 51, $k_p(t)$, output from the response control signal generator 50. In accordance with this invention, the response control signal generator 50 provides a response control signal 51 which exponentially decreases from time $t_1$ to $t_2$ as previously described.

Likewise, any lag pulses present at the lag output 54 control the operation of the positive charge source 44. The positive charge source 44 thus sources a current directly proportional to the width of the pulses on the lag output 54 as well as the value of the response control signal 51. The capacitor 48 is thereby allowed to charge.

An s-plane transfer function can be developed for the circuit of Fig. 2, which in turn quantifies the effect of the changes in gain of the charge pump 42 caused by varying the response control signal 51 in terms of the $w_n$ of the loop. In the following analysis, symbols are assigned to the various parameters:

| | |
|---|---|
| $k_p$ | instantaneous gain of charge pump 42 |
| $i_p$ | instantaneous current from charge pump 42 |
| $k_o$ /s | transfer function of VCO 26 |
| $\Phi_{in}$ | input signal 34 |
| $\Phi_e$ | phase error output of detector 4O |
| $\Phi_{out}$ | VCO output 27 |
| $v_c$ | voltage input to VCO 26 |
| c | capacitance of 48 |
| $\gamma_1$ | resistance of control resistor 49 times c |
| $\alpha$ | damping factor of loop |

Since the transfer function for the charge pump is

$$i_p = \Phi_e k_p$$

then from linear system theory,

$$V_c = \Phi_e k_p \frac{1 + \gamma_1 s}{c s} ,$$

and the loop function will be described by

$$\frac{\Phi_{out}}{\Phi_{in}} = \frac{(k_p k_o / c)(1 + \gamma_1 s)}{s^2 + (k_p k_o / c) \gamma_1 s + (k_p k_o / c)}$$

which is recognizable as a standard form transfer function of a second order systems having an

$$w_n = \sqrt{(k_p k_o / c)}$$

and

$\alpha = w_n \gamma_1 / 2$ .

In the circuit of Fig. 2, the resulting change in natural frequency, $w_c$, and hence response time, is proportional to the square root of a change in the value of the response control signal 51, $k_p(t)$.

Finally, a curve 56 of $k_p(t)$ versus time is also shown. As previously mentioned, the gain of the charge pump 42 (ie., the control on the loop response time) may be changed in any suitably exponentially decreasing fashion. An exponential change, as shown in curve 56, is optimum in the sense that the largest changes in loop bandwidth occur nearest the beginning of the preamble portion 34 of the loop input signal 12 (Fig. 1), when the loop bandwidth is greatest, and when the most time is available to accomplish phase lock. This can also be seen by considering that the rate of change of the exponential gain control function in the curve 56 approaches zero nearest the end of the preamble, at time $t_2$, when the loop is most vulnerable to being upset by largest changes in gain. Thus, while the bandwidth has become very small, any adverse affect of changes in bandwidth has been minimized, since the bandwidth is changing ever so slowly by time $t_2$. As will be seen also in connection with Fig. 4C, when the changes in gain have become sufficiently small near time $t_2$, the gain adjustment period $t_2$ - $t_1$ can actually be extended beyond the end of the preamble portion 34 into the data portion 36. This enables the use of a shorter preamble portion 34.

Figure 3 is a detailed circuit diagram of an embodiment of the response control signal generator 50. The circuit operates with two supply voltages $V_S$ an $V_{AG}$ to provide a ramping signal kp(t) having a maximum value $V_{go}$ (refer to plot 38 of figure 1) and linearly decreasing to the voltage $V_{end}$ between times $t_1$ and $t_2$.

Figs. 4A through 4C depict the results of simulations performed with computer models of a conventional phase locked loop and a phased locked loop constructed in accordance with the invention. They show how the invention is less susceptible to perturbation that previous devices. Fig. 4A plots waveforms of a prior phase locked loop circuit on a normalized time versus amplitude scale. Fig. 4A includes plots of a loop input signal 100a, a loop gain control signal 100b, and the resulting loop output signal 100c when the loop gain is abruptly changed at some point, $t_2$, after the loop has locked to an input preamble. Such gain control

signals having abrupt changes have been used with certain prior circuits. Referring also briefly to Fig. 1, the signal 100a represents the phase of the input of the PLL 10 (referred to as $\Phi_{in}$ in the above calculations), the signal 100b represents the gain control output 51 of the signal generator 50, and the signal 100c the phase of the output 27 of VCO 26. Another noise perturbation 105 was added to the loop input signal 100a just before time $t_2$. Note the large phase error transient 110 caused by this perturbation. The transient 110 is approximately twenty-two time units long and 0.5 amplitude units in magnitude.

Fig. 4B shows another loop input signal 120a, gain control signal 120b, and a loop output signal 120c associated with the PLL 10. The loop input signal 120a was kept identical to the previous input 100a, with a corresponding perturbation 125 near time $t_2$. However, 120b has a ramp portion 121b linearly decreasing to time $t_2$, rather than an abrupt change as for gain control signal 100b. Oscillations in loop error signal 120c caused as a result of the perturbation 125 are still clearly visible. Thus, by ramping the bandwidth decrease in the manner shown, the loop takes only approximately 17 time units, or almost twenty-five percent less time, to settle out. The amplitude has been reduced to 0.1 magnitude units, or about five times better. However, a gain transient still occurs at time $t_2$, just when the data portion is about to begin.

Fig. 4C illustrates a similar plot from which is discernible the advantages of this invention relating to susceptibility to the change in loop bandwidth itself. Plotted there are a family of gain control signals, 140a-140d, where the slope of the ramp portion 142 is varied, together with the corresponding loop phase error signals 145a-145d. As the slope of the ramp portion 142 is decreased (compare 140a with 140c), the resulting responses (compare 145a to 145c) "ring" less - that is, the resulting response is better damped. The traces 140d and 145d show the result of extending the ramp past the time $t_2$, into the data portion 36 of the loop input signal 12. The loop reaches its steady state at an even earlier time when this is done. Note particularly that in the situation shown with response signal 145d, the loop has settled after about 10 time units. In every other case, the loop requires additional time to settle. Thus, if the ramp function is so extended, the preamble portion 34 can be shortened even further, thereby shortening the time to phase lock the PLL 10.

The foregoing description has been limited to a specific embodiment of this invention. It will be apparent, however, that variations and modifications may be made to the invention, with the attainment of some or all of the advantages of the invention. For example, the present invention has been described as particularly useful for acquiring data from a disk drive. However, other data processing peripherals or systems needing in general to acquire a digital signal in minimum time may make use of the invention to their advantage. Therefore, it is the object of the appended claims to cover all such variations and modifications as come within the scope of the invention.

## Claims

**1.** A phase locked loop (10) arranged to receive an input signal (12) having a preamble portion (34) and a data portion (36), the phase locked loop (10) comprising:

A. signal generating means (50), for providing a response control signal (51) which monotonically decreases in amplitude beginning at a time when the phase locked loop receives the preamble portion (34) and continuing to exponentially decrease during at least a portion of the time that the phase locked loop receives the data portion (36); and

B. loop control means (42), coupled to the phase locked loop (10) and the signal generating means (50), for adjusting the response time of the phase locked loop (10) in accordance with the amplitude of the response control signal (51).

**2.** Apparatus as in claim 1 wherein the loop control means (42) additionally comprises:

a loop filter (48, 49), coupled to receive the response control signal (51), and responsive to the response control signal such that the bandwidth of the loop filter (48, 49) exponentially decreases in accordance with the monotonically amplitude change in the response control signal (51).

**3.** Apparatus as in claim 1 where the loop control means additionally comprises:

gain control means (44, 46), coupled to receive the response control signal (51), for adjusting the gain of the phase locked loop (10) such that the gain exponentially decreases in accordance with the monotonically amplitude change in the response control signal (51).

**4.** Apparatus as in claim 1 wherein the phase lock loop additionally comprises:

i. a voltage-controlled oscillator (VCO) having a voltage input control (26) and an output signal (27);

ii. a phase detector (40), coupled to receive a reference signal (34) and the VCO output signal (27), and providing pulsed lead (52) and lag (54) output signals; and

iii. a capacitor (48), and

wherein the loop control means additionally comprises:

iv. a charge pump (44,46), coupled to receive the lead (52) and lag (54)signals, and the response control signal (51), for incrementally discharging the capacitor (48) when a pulse is received from the lead signal (52), indicating that the reference signal (34) is leading the VCO output signal (27), and for incrementally charging the capacitor (48) when a pulse is received on the lag signal (54), indicating that the reference signal (51) is lagging the VCO output signal (27), the charge pump (44, 46) also having an increment control input which receives the response control signal (51) to control the magnitude of the incremental charge or incremental discharge.

**5.** Apparatus as in claim 4 wherein the loop control means (42) additionally comprises:

means for adjusting the increment control input of the charge pump (44, 46) so that it exponentially decreases from an initial relatively high value at a first time when the phase locked loop begins to receive the preamble portion (34), to a later relatively lower value at a second time when the phase locked loop stops receiving the preamble portion (34), the time difference between the first and second times at least as long as a loop time constant equal to the reciprocal of a natural frequency of the phase locked loop (10).

## Patentansprüche

**1.** Phasenregelkreis (PLL) (10), der ausgelegt ist, ein Eingangssignal (12) mit einem Einleitungs-Abschnitt (34) und einem Datenabschnitt (36) zu empfangen, wobei der Phasenregelkreis (10) aufweist:

A. eine Signalerzeugungseinrichtung (50) zum Erzeugen eines Antwortsteuer-Signals (51), das monoton in der Amplitude abnimmt, was zu einem Zeitpunkt beginnt, wenn der Phasenregelkreis den Einleitungsabschnitt (34) empfängt, und das mit einer exponentiellen Abnahme während zumindest einem Abschnitt der Zeit fortfährt, in der der Phasenregelkreis den Datenabschnitt (36) empfängt; und

B. eine Kreissteuereinrichtung (42), die mit dem Phasenregelkreis (10) und der Signalerzeugungseinrichtung (50) verbunden ist, zum Einstellen der Antwortzeit des Phasenregelkreises (10) in Übereinstimmung mit der Amplitude des Antwortsteuer-Signals (51).

**2.** Vorrichtung nach Anspruch 1, worin die Kreissteuereinrichtung (42) zusätzlich aufweist:

einen Kreisfilter (48, 49), der verbunden ist, das Antwortsteuer-Signal (51) zu empfangen, und der auf das Antwortsteuer-Signal so reagiert, daß die Bandbreite des Kreisfilters (48, 49) exponentiell in Übereinstimmung mit der monotonen Amplitudenänderung des Antwortsteuer-Signals (51) abnimmt.

**3.** Vorrichtung nach Anspruch 1, worin die Kreissteuereinrichtung zusätzlich aufweist:

eine Verstärkungs-Steuereinrichtung (44, 46), die verbunden ist, um das Antwortsteuer-Signal (51) zu empfangen, zum Einstellen der Verstärkung des Phasenregelkreises (10), so daß die Verstärkung exponentiell in Übereinstimmung mit der monotonen Amplitudenänderung des Antwortsteuer-Signals (51) abnimmt.

**4.** Vorrichtung nach Anspruch 1, worin der Phasenregelkreis zusätzlich aufweist:

i. einen spannungsgesteuerten Oszillator (VCO), der eine Spannungseingangssteuerung(26) und ein Ausgangssignal (27) hat;

ii. einen Phasendetektor (40), der verbunden ist, um ein Referenzsignal (34) und das VCO-Ausgangssignal (27) zu empfangen, und der gepulste vorauseilende (52) und hinterhereilende (54) Ausgangssignale erzeugt; und

iii. einen Kondensator (48), und

worin die Kreissteuereinrichtung zusätzlich aufweist:

iv. eine Ladungspumpe (44, 46), die verbunden ist, um die vorauseilenden (52) und hinterhereilenden (54) Signale und das Antwortsteuer-Signal (51) zu empfangen, zum inkrementalen Entladen des Kondensators (48), wenn ein Impuls des vorauseilenden Signals (52) empfangen wird, der anzeigt, das das Referenzsignal (34) dem VCO-Ausgangssignal (27) vorauseilt, und zum inkrementalen Aufladen des Kondensators (48), wenn ein Impuls des hinterhereilenden Signales (54) empfangen wird, der anzeigt, daß das Referenzsignal (51) dem VCO-Ausgangssignal (27) hinterhereilt, wobei die

Ladungspumpe (44, 46) auch einen Inkremental-Steuereingang aufweist, der das Antwortsteuer-Signal (51) empfängt, um die Größe der Inkremental-Aufladung oder der Inkremental-Entladung zu steuern.

**5.** Vorrichtung nach Anspruch 4, worin die Kreissteuereinrichtung (42) zusätzlich aufweist:
eine Einrichtung zum Einstellen des Inkremental-Steuereingangs der Ladungspumpe (44, 46), so daß er exponentiell von einem anfänglichen, relativ hohen Wert zu einem ersten Zeitpunkt, wenn der Phasenregelkreis damit beginnt, den Einleitungsabschnitt (34) zu empfangen, auf einen späteren, relativ niedrigen Wert zu einem zweiten Zeitpunkt abnimmt, wenn der Phasenregelkreis aufhört, den Einleitungsabschnitt (34) zu empfangen, wobei die Zeitdifferenz zwischen dem ersten und dem zweiten Zeitpunkt zumindest so lang ist wie eine Kreis-Zeitkonstante, die gleich dem Umkehrwert einer Eigenfrequenz des Phasenregelkreises (10) ist.

**Revendications**

**1.** Boucle à phase asservie (10) conçue pour recevoir un signal d'entrée (12) qui possède une partie de préambule (34) et une partie de données (36), la boucle à phase asservie (10) comportant :
A. des moyens générateurs de signaux (50) destinés à fournir un signal de commande de réponse (51) dont l'amplitude diminue d'une manière monotone à partir d'un moment où la boucle à phase asservie reçoit la partie de préambule (34) pour continuer à diminuer exponentiellement pendant au moins une partie du temps durant lequel la boucle à phase asservie reçoit la partie de données (36); et
B. des moyens de commande de boucle (42) reliés à la boucle à phase asservie (10) et aux moyens générateurs de signaux (50) pour ajuster le temps de réponse de la boucle à phase asservie (10) en fonction de l'amplitude du signal de commande de réponse (51).

**2.** Appareil selon la revendication 1, dans lequel les moyens de commande de boucle (42) comportent aussi :
un filtre de boucle (48, 49) monté pour recevoir le signal de commande de réponse (51) et sensible au signal de commande de réponse de façon que la largeur de bande du filtre de boucle (48, 49) diminue exponentiellement en fonction de la variation d'amplitude monotone du signal de commande de réponse (51).

**3.** Appareil selon la revendication 1, dans lequel les moyens de commande de boucle comportent en outre :
des moyens de commande de gain (44, 46) montés pour recevoir le signal de commande de réponse (51) en vue d'ajuster le gain de la boucle à phase asservie (10) de façon que le gain diminue exponentiellement en fonction de la variation d'amplitude monotone du signal de commande de réponse (51).

**4.** Appareil selon la revendication 1, dans lequel la boucle à phase asservie comporte également :
i. un oscillateur commandé en tension (VCO) qui possède une commande d'entrée de tension (26) et un signal de sortie (27);
ii. un détecteur de phase (40) monté pour recevoir un signal de référence (34) et le signal de sortie de VCO (27) et fournissant des signaux de sortie impulsionnels d'avance (52) et de retard (54); et
iii. un condensateur (48), et
dans lequel les moyens de commande de boucle comportent aussi:
iv. une pompe à charge (44, 46) montée pour recevoir les signaux d'avance (52) et de retard (54) ainsi que le signal de commande de réponse (51) en vue de décharger d'une manière incrémentielle le condensateur (48), lorsqu'elle reçoit du signal d'avance (52) une impulsion indiquant que le signal de référence (34) est en avance par rapport au signal de sortie de VCO (27), et de charger d'une manière incrémentielle le condensateur (48), lorsqu'elle reçoit sur le signal de retard (54) une impulsion indiquant que le signal de référence (51) est en retard par rapport au signal de sortie de VCO (27), la pompe à charge (44, 46) comportant également une entrée de commande d'incrémentation qui reçoit le signal de commande de réponse (51) pour commander l'amplitude de la charge incrémentielle ou de la décharge incrémentielle.

**5.** Appareil selon la revendication 4, dans lequel les moyens de commande de boucle (42) comportent de surcroît :

des moyens destinés à ajuster l'entrée de commande d'incrémentation de la pompe à charge (44, 46) afin qu'elle diminue exponentiellement d'une valeur initiale relativement élevée dans un premier temps, lorsque la boucle à phase asservie commence à recevoir la partie de préambule (34), à une valeur ultérieure relativement inférieure dans un second temps, lorsque la boucle à phase asservie cesse de recevoir la partie de préambule (34), la différence de temps entre les premier et second temps étant au moins aussi longue qu'une constante de temps de boucle égale à l'inverse d'une fréquence propre de la boucle à phase asservie.

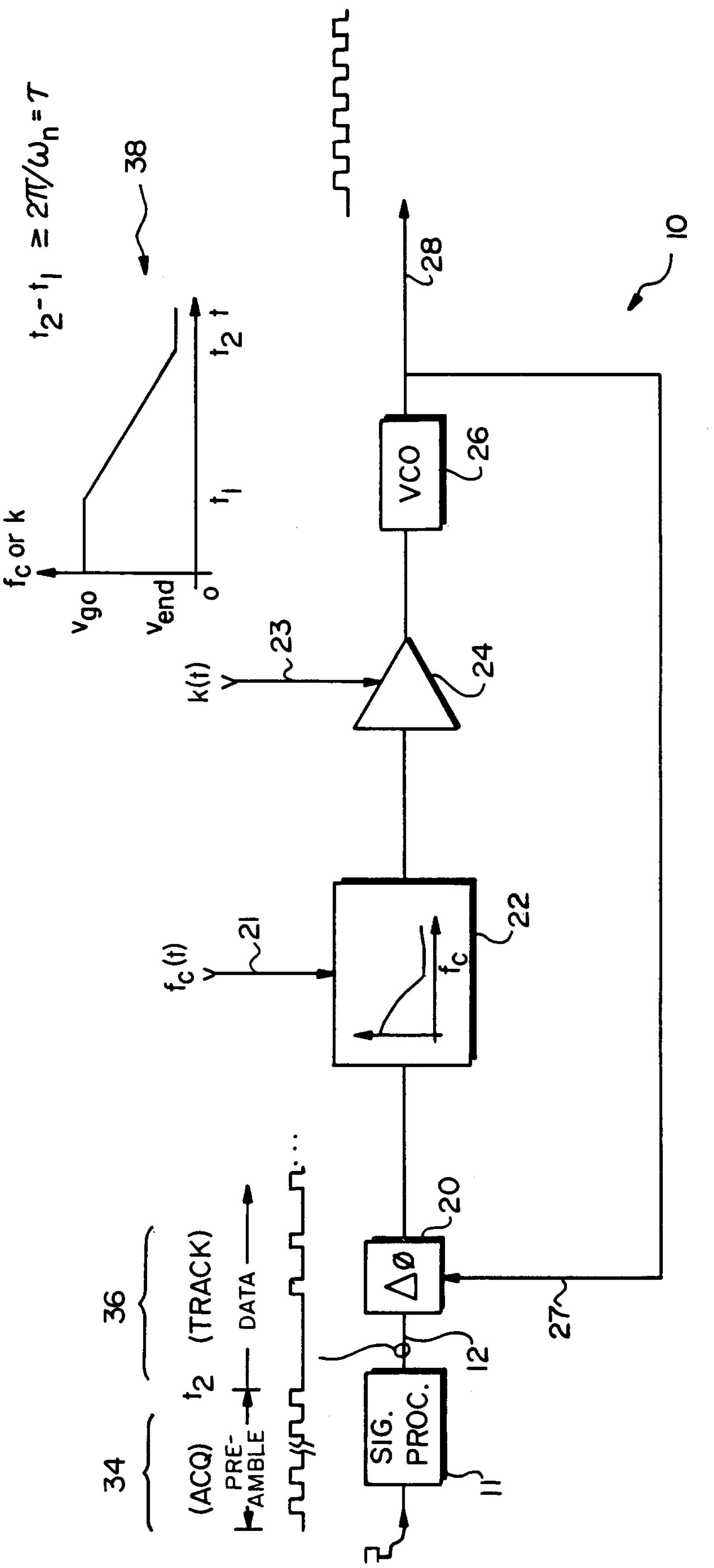
$t_2 - t_1 \geq 2\pi/\omega_n = T$
38
$f_c$ or k
$v_{go}$
$v_{end}$
o
$t_1$
$t_2$
t
k(t)
23
$f_c(t)$
21
22
$f_c$
24
VCO
26
28
10
34
36
(ACQ)
PRE-
AMBLE
$t_2$
(TRACK)
DATA
SIG.
PROC.
11
12
Δø
20
27

FIG. 1

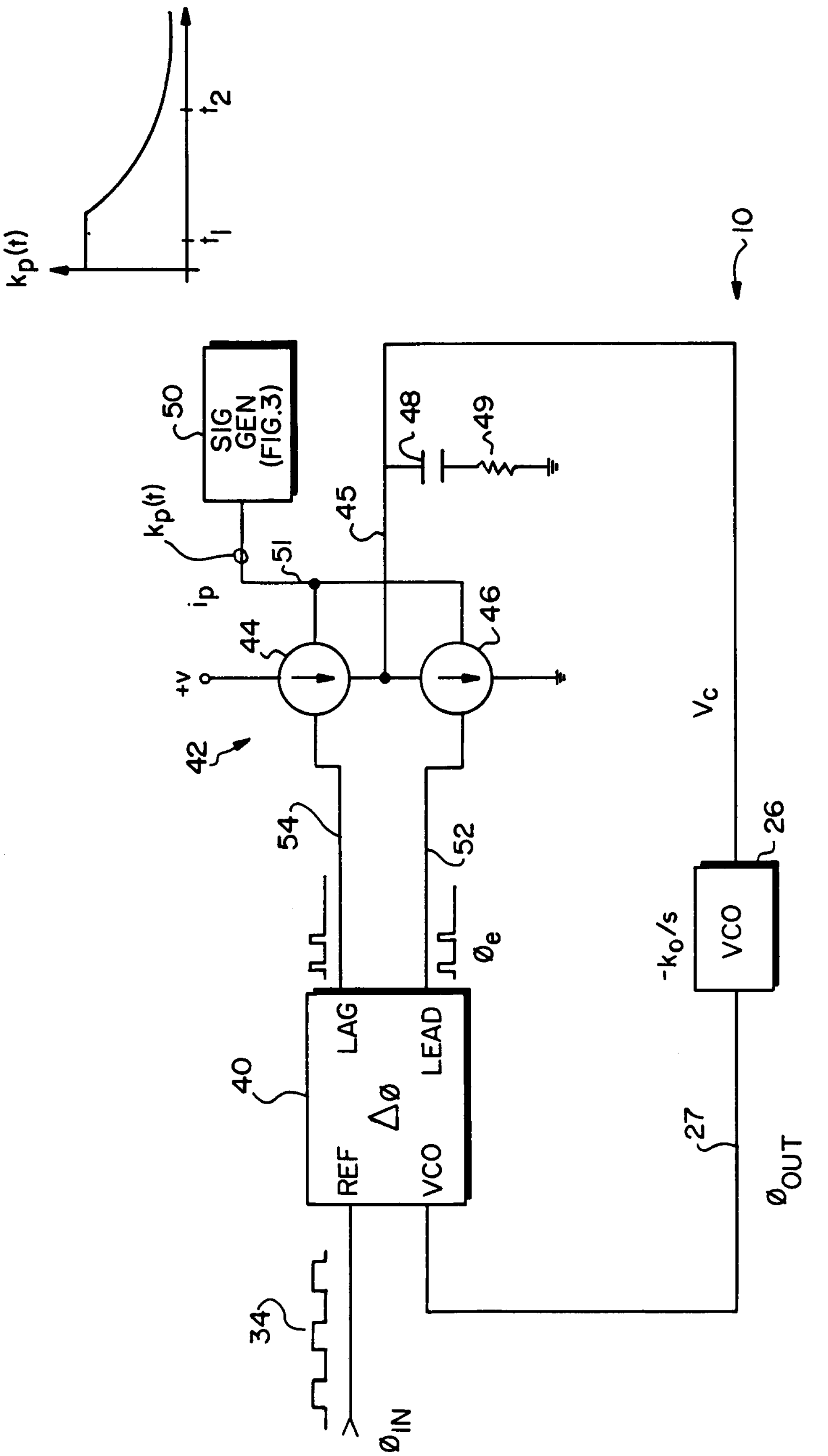

$k_p(t)$
$t_1$
$t_2$
10
50
SIG GEN (FIG.3)
$k_p(t)$
$i_p$
51
45
48
49
+v
44
46
42
54
52
$Ø_e$
40
REF
LAG
$\Delta Ø$
VCO
LEAD
$V_c$
26
$-k_o/s$
VCO
27
$Ø_{OUT}$
34
$Ø_{IN}$


FIG. 2

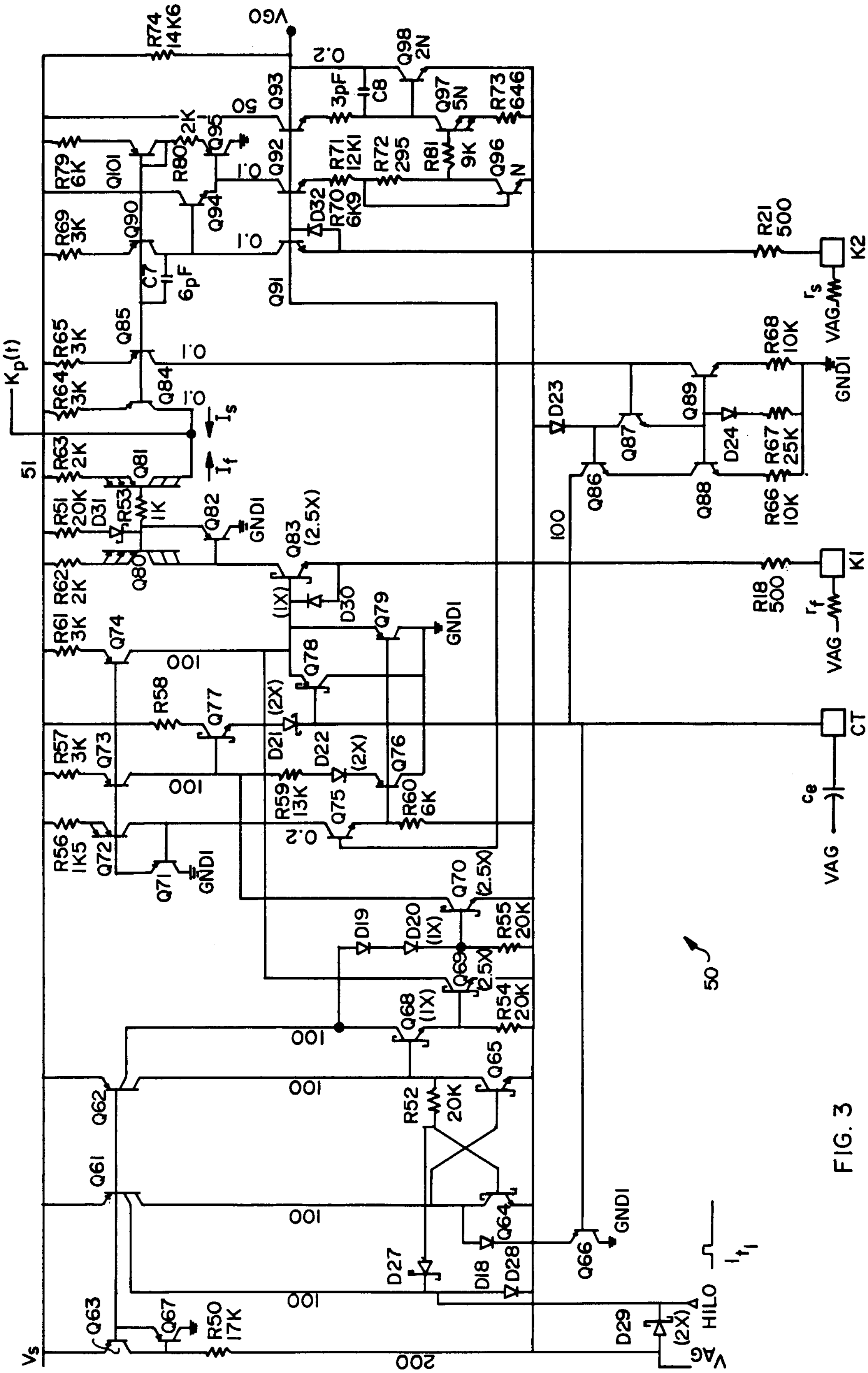
VGO
R74 14K6
Kp(t)
Is
If
51
Q91
Q92
Q93
Q98 2N
C8
3pF
Q97 5N
R73 646
Q96 N
R81 9K
R72 295
R71 12K1
R70 6K9
D32
Q94
Q95
R80 2K
Q101
R79 6K
R69 3K
Q90
C7 6pF
R65 3K
Q85
R64 3K
Q84
R63 2K
Q81
R51 20K
D31
R53 1K
Q82
GNDI
Q80
R62 2K
Q83 (2.5X)
(1X)
D30
Q79
R61 3K
Q74
Q78
D21 (2X)
D22 (2X)
R58
Q77
R57 3K
Q73
Q76
R59 13K
R60 6K
Q75
R56 1K5
Q72
Q71
Q70 (2.5X)
R55 20K
D19
D20 (1X)
Q69 (2.5X)
R54 20K
Q68 (1X)
Q65
Q62
Q61
R52 20K
Q64
Q66
D27
D18
D28
Q63
Q67
R50 17K
Vs
HILO
D29 (2X)
VAG
Itl
R21 500
K2
rs
R68 10K
Q89
D23
Q87
Q86
Q88
D24
R67 25K
R66 10K
R18 500
K1
rf
CT
ce
50

FIG. 3

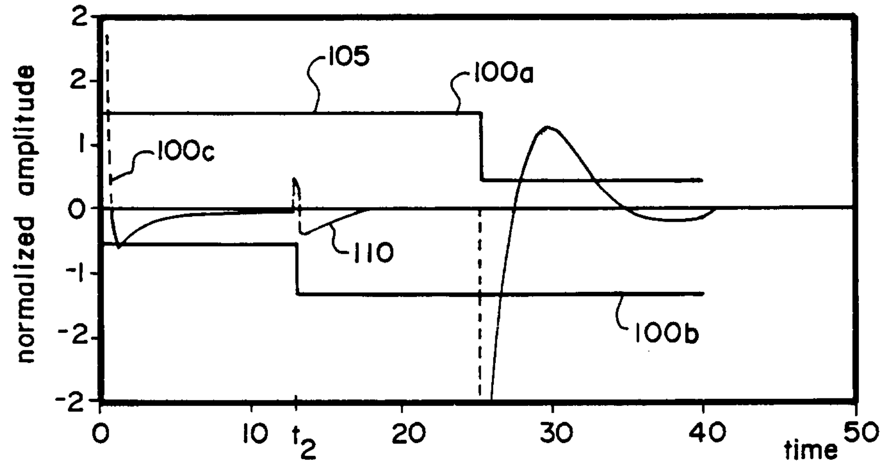

2
2
1
0
-1
-2
-2
normalized amplitude
105
100a
100c
110
100b
0
10
$t_2$
20
30
40
time
50


FIG. 4A

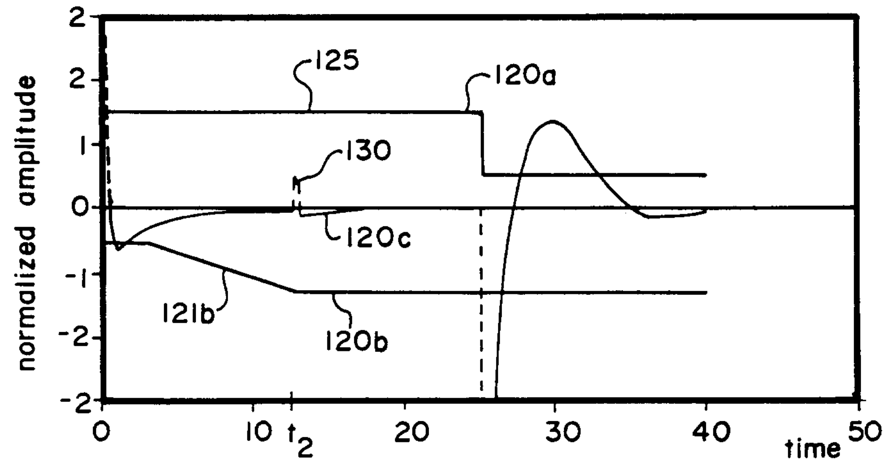

2
2
1
0
-1
-2
-2
normalized amplitude
125
120a
130
120c
121b
120b
0
10
$t_2$
20
30
40
time
50


FIG. 4B

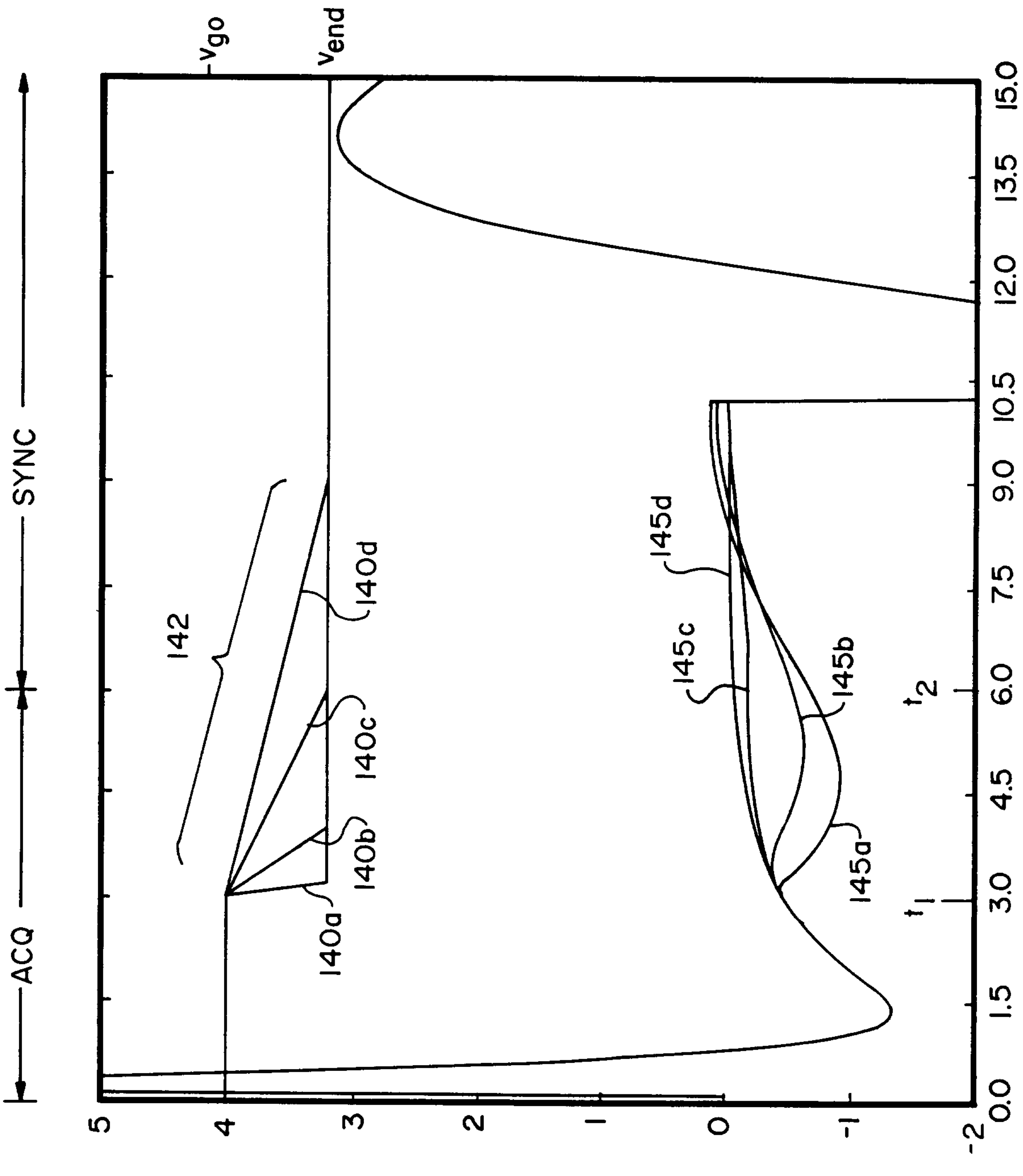
ACQ
SYNC
$v_{go}$
$v_{end}$
142
140a
140b
140c
140d
145a
145b
145c
145d
$t_1$
$t_2$
5
4
3
2
1
0
-1
-2
0.0
1.5
3.0
4.5
6.0
7.5
9.0
10.5
12.0
13.5
15.0

FIG. 4C